(19) Europäisches Patentamt
European Patent Office
Office européen des brevets

(11) **EP 3 483 930 B1**

(12) **EUROPÄISCHE PATENTSCHRIFT**

(45) Veröffentlichungstag und Bekanntmachung des Hinweises auf die Patenterteilung:
**09.08.2023  Patentblatt 2023/32**

(21) Anmeldenummer: **18180232.3**

(22) Anmeldetag: **27.06.2018**

(51) Internationale Patentklassifikation (IPC):
**H01L 23/367** (2006.01)   **H01L 23/42** (2006.01)
**H05K 1/02** (2006.01)

(52) Gemeinsame Patentklassifikation (CPC):
**H01L 23/3675; H01L 23/42; H05K 1/0209;**
H05K 3/284

(54) **ELEKTRONIKBAUEINHEIT**

ELECTRONIC UNIT

UNITE ELECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.11.2017  DE 202017106861 U**
**05.12.2017  DE 102017128928**

(43) Veröffentlichungstag der Anmeldung:
**15.05.2019  Patentblatt 2019/20**

(73) Patentinhaber: **Valeo Thermal Commercial Vehicles Germany GmbH**
**82205 Gilching (DE)**

(72) Erfinder: **REDELBERGER, Harald**
**97273 Kürnach (DE)**

(74) Vertreter: **Strasser, Wolfgang et al**
**Patentanwälte**
**Strohschänk, Uri, Strasser & Keilitz**
**Rudolf-Diesel-Strasse 14**
**85521 Ottobrunn-Riemerling (DE)**

(56) Entgegenhaltungen:
DE-A1- 4 009 445       DE-A1- 10 249 436
JP-A- 2003 244 959     US-A1- 2002 054 480
US-A1- 2008 006 915    US-A1- 2008 073 784
US-A1- 2012 293 963    US-B1- 6 657 864
US-B1- 6 853 068

**Beschreibung**

Die Erfindung betrifft eine Elektronikbaueinheit der im Oberbegriff von Anspruch 1 genannten Art.

In vielen elektronischen Anwendungen kommen Leistungsbauelemente mit einer vergleichsweise hohen Verlustleistung zum Einsatz. Die hierbei entstehende Wärme würde ohne weitere Maßnahmen zu einer erheblichen Er- bzw. Überhitzung nicht nur des Leistungsbauelements selbst sondern auch der in seiner unmittelbaren Nähe befindlichen elektronischen Bauelemente insbesondere dann führen, wenn diese auf die gleiche Leiterplatte montiert sind.

Um dies zu vermeiden und die Lebensdauer der Bauelemente nicht durch einen Betrieb jenseits ihrer Spezifikationen zu verkürzen, ist es üblich, Wärme-Abführkörper zu verwenden, die im vorliegenden Text so, wie allgemein üblich, als Kühlkörper bezeichnet werden, obwohl streng genommen durch sie keine aktive Kühlung der elektronischen Bauelemente stattfindet.

Solche Kühlkörper bestehen im Regelfall aus einem Metall hoher Wärmeleitfähigkeit, meistens Aluminium, und weisen einen beispielsweise quaderförmigen Hauptkörper auf, der auf einer seiner Seiten eine Vielzahl von mit gegenseitigen Abständen angeordneten Rippen besitzt, durch die ein möglichst großflächiger und inniger Kontakt mit der Umgebungsluft gewährleistet ist, an welche die störende Wärme abgeführt wird.

Moderne Leistungsbauelemente weisen im Allgemeinen ein aus Kunststoff bestehendes Gehäuse auf, das einen vergleichsweise hohen Wärmewiderstand bildet. Um dennoch eine gute Wärmeabfuhr zu gewährleisten, ist der die Wärme erzeugende Chip häufig auf einer metallischen Grundplatte montiert, die als Kühlfahne bzw. Kühlflansch aus dem Gehäuse heraus nach außen geführt ist. Dieser Kühlflansch wird nach dem Stand der Technik mit einer Schraube oder dergleichen auf einem Kühlkörper der oben beschriebenen Art befestigt.

Da sich in vielen Fällen die Kühlfahne auf einem von der Systemmasse verschiedenen Potenzial befindet, das überdies von Bauelement zu Bauelement unterschiedlich sein kann, muss bei der beschriebenen Montageart zwischen dem Kühlflansch des Leistungsbauelementes und dem Kühlkörper ein elektrisch isolierendes Bauteil, beispielsweise ein Glimmerplättchen oder eine Silikonfolie angebracht werden, damit der Kühlkörper potenzialfrei bleiben oder die Wärme mehrerer, ein unterschiedliches elektrisches Potenzial besitzender Leistungsbauelemente mithilfe eines gemeinsamen Kühlkörpers abgeführt werden kann. Diese elektrisch isolierenden Elemente besitzen jedoch einen hohen thermischen Widerstand.

Ein Beispiel für eine Schaltungsanordnung, bei der diese Probleme auftreten, ist ein Schalttransistor mit Freilaufdiode für induktive Lasten; hier liegt die mit dem Diodengehäuse verbundene Kathode der Freilaufdiode auf einem anderen Potenzial als der mit dem Transistorgehäuse verbundene Kollektor des Bipolartransistors.

Nicht zuletzt tritt dieses Problem auch bei Bauelementen mit einem sogenannten SMD-Gehäuse (surface mounted device = oberflächenmontiertes Bauelement) auf, die auf der Außenseite ihres Kunststoffgehäuses eine als Kühlfahne dienende Grundplatte besitzen die auf dem elektrischen Potenzial eines der Bauelementanschlüsse liegt.

Die DE 102 49 436 A1 offenbart eine Elektronikbaueinheit, die zur Kühlung eines auf einer Platine montierten Leistungsbauelementes einen Kühlkörper umfasst, der einen Hauptkörper aus wärmeleitendem Material, vorzugsweise Metall umfasst, auf dessen Oberseite Kühlrippen vorgesehen sind. In die Unterseite des Hauptkörpers ist ein Hohlraum eingelassen, in den nach Montage des Kühlkörpers das Leistungsbauelement hineinragt. Ansonsten weist der Hauptkörper an seiner Unterseite Flächenbereiche auf, die nach der Montage einen thermischen Kontakt zu einer Platine etablieren, auf der sich das Leistungsbauelement befindet, dessen Verlustwärme nur über eine Keramik-Kupfer-Platine abgeführt werden kann, die aufgrund einer auf sie aufgebrachten Kupferschicht eine sehr hohe Wärmeleitfähigkeit aufweist. Der Kühlkörper umfasst seitliche, mit ihm einstückig verbundene Klemmvorsprünge mit Nasen zur Fixierung der Platine, die beim Montieren an der Unterseite der Platine so einrasten, dass zwischen den planaren Flächen des Kühlkörpers und der Kupferschicht der Platine ein mechanischer Andruck erzielt wird. Das Leistungsbauelement umfasst ein aus Kunststoff bestehendes Gehäuse das mit einer seiner Flachseiten an der Platine anliegt. Die Wärmeabfuhr erfolgt somit im wesentlichen einseitig durch das wegen seiner großen Wandstärke eine geringe Wärmeleitfähigkeit aufweisende Gehäuse zur Kupferschicht der Platine und von dieser zum Kühlkörper.

Die US 2008/0006915 A1 zeigt mehrere Ausführungsformen einer Elektronikbaugruppe, die eine Leiterplatte, einen Halbleiterchip und einen Kühlkörper umfasst, wobei letzterer einen plattenförmigen Teil aufweist, auf dessen der Leiterplatte zugewandten Unterseite eine nach unten vorspringende Struktur ausgebildet ist, die einen trogförmigen, nach unten offenen Hohlraum umschließt, in den im zusammengebauten Zustand der Halbleiterchip von unten her hineinragt. Das vom Halbleiterchip freigelassene Volumen des Trogs ist mit einem metallischen Kontaktmaterial gefüllt, mit dessen Hilfe der Kühlkörper mit der Leiterplatte verlötet wird, die zu diesem Zweck auf ihrer Oberseite eine als "metallic pad" bezeichnete Verbindungsstruktur aufweist. Die Unterseite des elektronischen Bauelementes liegt über sogenannte "bumps" auf der Leiterplatte auf.

Aus der DE 40 09 445 A1 ist eine Elektronikbaueinheit bekannt, bei der die elektronischen Leistungsbauelemente in sogenannten Dual-Inline-Gehäusen untergebracht sind, die an ihren beiden Längsseiten zur Leiterplatte hin umgebogene Kontaktbeinchen aufweisen, die in entsprechende Bohrungen der Leiterplatte eingeführt und dort so verlötet sind, dass die der Leiterplatte zugewandte Oberfläche des Gehäuses einen Abstand zur Leiterplatte aufweist. Dadurch ergibt sich zwischen dem Gehäuse des Leistungsbauelementes und der Leiterplatte ein schlecht wärmeleitendes Luftvolumen, dessen Auffüllung mit einem gut wärmeleitenden Material praktisch unmöglich ist. Somit findet zwischen der Leiterplatte zugewandten Oberfläche des Gehäuses und der Leiterplatte so gut wie kein Wärmeübergang statt.

Demgegenüber liegt der Erfindung die Aufgabe zugrunde, eine Elektronikbaueinheit der eingangs genannten Art zu schaffen, deren Zusammenbau wesentlich vereinfacht ist und bei der gleichzeitig eine optimale Kühlung des elektronischen Leistungsbauelementes sichergestellt ist.

Zur Lösung dieser Aufgabe sieht die Erfindung die im Anspruch 1 zusammengefassten Merkmale vor.

Den erfindungsgemäßen Maßnahmen liegen folgende Überlegungen zu Grunde:
Dadurch, dass bei den elektronischen Leistungsbauelementen anstelle von Dual-Inline-Gehäusen sogenannte SMD-Gehäuse zum Einsatz kommen, deren elektrische Anschlüsse mit einer Gehäuse-Oberfläche plan abschließen, und dadurch, dass diese Oberfläche eng an der die Leiterbahnen tragenden Flachseite der Leiterplatte anliegt, und dass weiterhin zumindest in der Umgebung des elektronischen Leistungsbauelements der Freiraum zwischen der Leiterplatte und dem Kühlkörper mit einer Schicht aus einem elektrisch isolierenden und gut wärmeleitenden Kontaktmaterial zumindest teilweise ausgefüllt ist, wird ein optimaler Wärmeübergang zwischen dem Leistungsbauelement bzw. dessen Gehäuse und der Leiterplatte erzielt, die eine weitere Wärmeableitung ermöglicht. Gleichzeitig dient das Gehäuse des elektronischen Leistungsbauelements als Abstandshalter zwischen dem Kühlkörper und der Leiterplatte, wodurch sich sowohl der Auf- als auch der Zusammenbau einer erfindungsgemäßen Elektronikbaueinheit erheblich vereinfacht.

Der Wärmestrom, durch den die von einem Leistungsbauelement erzeugte Verlustleistung zur Umgebung abgeführt wird, kann in Analogie zum Ohmschen Gesetz durch folgende Gleichung dargestellt werden:

$$T_B - T_U = P_V * R_{th}$$

Dabei bedeutet $T_B$ die Temperatur des Bauelements, Tu die Umgebungstemperatur, $P_V$ die abzuführende Verlustleistung und $R_{th}$ die Summe der vom Wärmestrom auf dem Weg vom Bauelement zur Umgebungsluft zu überwindenden thermischen Widerstände.

Aus dieser Gleichung ergibt sich, dass bei vorgegebener Verlustleistung Pv die Bauelementtemperatur $T_B$ umso höher über der Umgebungstemperatur $T_U$ liegt, je größer der thermische Gesamtwiderstand $R_{th}$ ist.

Da die Temperatur $T_B$ des Bauelements (insbesondere die des Bauelement-Chips) einen vorgegebenen Maximalwert nicht übersteigen darf, um seine Lebensdauer bzw.

Funktionstüchtigkeit nicht zu gefährden, muss, weil die abzuführende Verlustleistung $P_V$ betriebsbedingt im Wesentlichen vorgegeben ist, und weil die Umgebungstemperatur nur mit einem vergleichsweise großen technischen Aufwand abgesenkt werden kann, der thermische Gesamtwiderstand $R_{th}$ so klein wie irgend möglich gehalten werden.

Der thermische Widerstand des vom elektronischen Leistungsbauelement zum Kühlkörper führenden Abflussweges ist umso größer, je größer die Länge dieses Weges, und umso kleiner, je größer seine (mittlere) Querschnittsfläche ist. Um einen möglichst geringen thermischen Widerstand zu erzielen, kommt es also darauf an, die Länge des Abflussweges möglichst klein und seine Querschnittsfläche möglichst groß auszugestalten.

Dadurch, dass gemäß der Erfindung das wenigstens eine elektronische Leistungsbauelement als Abstandshalter zwischen dem Kühlkörper und der Leiterplatte dient, wobei die von der Leiterplatte abgewandte Seite seines Gehäuses an dem wenigstens einen Flächenbereich des Kühlkörpers anliegt, wird die Länge des Abflussweges für die vom elektronischen Leistungsbauelement erzeugte Wärme zum Kühlkörper auf ein Minimum reduziert.

Wenn im vorliegenden Zusammenhang davon die Rede ist, dass ein Kontaktmaterial "zumindest" gut wärmeleitend sein soll, so bedeutet dies, dass es darüber hinaus auch eine hohe elektrische Isolationsfähigkeit besitzen kann, aber nicht besitzen muss.

Wesentlich ist, dass das Kontaktmaterial zumindest im Zeitpunkt des Zusammenbaus der Elektronikbaueinheit verformbar ist, sodass es sich an die beiden miteinander in Kontakt zu bringenden Oberflächen, nämlich die des Leistungsbauelements einerseits und die des Kühlkörpers andererseits anschmiegen und dabei eventuell vorhandene Unebenheiten ausgleichen kann, wie sie zum Beispiel durch Grate oder elektrisch leitende Partikel verursacht werden können, die bei der Montage zwischen die beiden aneinander zur Anlage kommenden Flächen geraten.

Außerdem dient diese Schicht dazu, einen beispielsweise bei einer verkanteten Montage auftretenden ungleichförmigen Zwischenraum zwischen dem Gehäuse des elektronischen Leistungsbauelements und der bzw. dem ihm zugewandten Oberflächen des Kühlkörpers vollständig auszufüllen. Wesentlich ist, dass zumindest über die gesamte Fläche, die das Gehäuse des elektronischen Leistungsbauelements dem Kühlkörper zuwendet, ein ausgezeichneter, gleichförmiger Wärmekontakt vorhanden ist.

Als Kontaktmaterial wird vorzugsweise eine plastisch verformbare Wärmeleitpaste, beispielsweise ein sogenannter Gap-Filler verwendet, der überdies den Vorteil aufweist, dass er gute elektrische Isolationseigenschaften besitzt.

Da bei einem Leistungsbauelement, dessen Gehäuse ausschließlich aus Kunststoff besteht, zur Kühlung der vergleichsweise hohe thermische Übergangswiderstand des Gehäuses überwunden werden muss, werden bevorzugt Leistungsbauelemente verwendet, deren Gehäuse einen Kühlflansch aufweist. Dabei erfolgt die Montage vorzugsweise durch Löten so, dass dieser Kühlflansch an der Leiterplatte anliegt. Dabei bildet das Lot vorteilhafterweise eine dünne Schicht aus einem Kontaktmaterial, das in diesem Fall sowohl gut elektrisch leitend als auch gut wärmeleitend ist, sich zwischen dem Kühlflansch und der Leiterplatte befindet und eventuell vorhandene Unebenheiten ausgleicht und somit das Entstehen von mit Luft gefüllten und daher wärmemäßig isolierenden Hohlräumen vermeidet.

In bei einer solchen Anordnung führt der kürzeste Abflussweg für die Verlustwärme vom Bauelement-Chip zum Kühlkörper zwar ebenfalls durch den einen hohen spezifischen thermischen Widerstand besitzenden Kunststoffbereich des Bauelementgehäuses, doch kann dieses Problem einerseits dadurch gemindert werden, dass Bauelemente mit einer möglichst geringen Gehäuse-Wandstärke verwendet werden.

Andererseits wird in Ergänzung hierzu erfindungsgemäß ein zu diesem kürzesten Abflussweg paralleler Wärmeleitpfad geschaffen, der aufgrund des innigen Kontaktes zwischen dem Kühlflansch und der Leiterplatte zunächst vom Bauelement-Chip weg in die das Leistungsbauelement umgebenden Bereiche der Leiterplatte hinein führt.

Da in der Umgebung des elektronischen Leistungsbauelements gemäß der Erfindung auch der Freiraum zwischen der Leiterplatte und der ihr zugewandten Oberseite des Kühlkörpers mit einem gut wärmeleitenden und gleichzeitig elektrisch gut isolierenden Kontaktmaterial ausgefüllt ist, kann ein großer Teil der vom Leistungsbauelement erzeugten Verlustleistung zunächst parallel zur Ebene der Leiterplatte zur Verteilung weitergeleitet und dann in seiner Flussrichtung umgelenkt werden, sodass sie durch das Kontaktmaterial hindurch in den Kühlkörper gelangt

Dieser parallele Wärme-Abflussweg ist zwar etwas länger, besitzt aber eine erheblich vergrößerte Querschnittsfläche, die zu einem insgesamt verringerten Wärmewiderstand führt.

Somit ergibt sich dadurch, dass sowohl der Abstand der Leiterplatte von dem ihr zugewandten Flächenbereich des Kühlkörpers und damit die Dicke der diesen Freiraum ausfüllenden Schicht des wärmeleitenden Kontaktmaterials sehr klein ist, als auch dadurch, dass die Ausdehnung dieser Schicht parallel zur Leiterplatte im Vergleich zur Größe des Leistungsbauelementes sehr groß gewählt werden kann, insgesamt ein äußerst kleiner thermischer Gesamtwiderstand.

Für elektronische Leistungsbauelemente, die kein oberflächenmontiertes Gehäuse besitzen, kann in vorteilhafter Weise vorgesehen sein, dass auch zwischen der der Leiterplatte zugewandten Gehäuseseite und der Leiterplatte eine Schicht eines elektrisch isolierenden und gut wärmeleitenden Kontaktmaterials vorhanden ist, sodass auch hier der oben erwähnte Effekt der Wärmeableitung und Wärmeverteilung parallel zur Ebene der Leiterplatte stattfindet.

Um den Abstand zwischen der dem Kühlkörper zugewandten Flachseite der Leiterplatte und der ihr gegenüberliegenden Oberseite des Kühlkörpers so klein wie irgend möglich zu gestalten, ist in besonders bevorzugter Weise vorgesehen, dass die Oberseite des Kühlkörpers wenigstens zwei Flächenbereiche aufweist, die im montierten Zustand unterschiedliche Abstände von der Leiterplatte besitzen. In diesem Fall liegt dann das den Abstandshalter bildende elektronische Leistungsbauelement mit seinem Gehäuse an dem einen, einen größeren Abstand von der Leiterplatte aufweisenden Flächenbereich des Kühlkörpers an, während der Bereich der Flachseite der Leiterplatte, der das elektronische Leistungsbauelement umgibt, dem anderen Flächenbereich der Oberseite des Kühlkörpers in einem Abstand gegenüberliegt, der kleiner als die Höhe des elektronischen Leistungsbauelements senkrecht zur Leiterplatte ist.

Insbesondere kann die Differenz der Abstände, welche die wenigstens zwei Flächenbereiche des Kühlkörpers von der Leiterplatte besitzen, so auf die Höhe des Gehäuses des Leistungsbauelementes abgestimmt sein, dass sich zwischen der dem Kühlkörper zugewandten Flachseite der Leiterplatte und dem ihm gegenüberliegenden Flächenbereich des Kühlkörpers ein Freiraum mit minimaler Höhe ergibt, der ohne großen Materialaufwand großflächig mit einem elektrisch isolierenden und gut wärmeleitenden Kontaktmaterial ausgefüllt werden kann, sodass eine optimale Wärmeableitung weg von der Leiterplatte in den Kühlkörper hinein stattfindet.

Vorzugsweise kann der Flächenbereich, der im zusammengebauten Zustand den größeren Abstand zur Leiterplatte besitzt, den Boden einer in der Oberseite des Kühlkörpers ausgebildeten, trogförmigen Vertiefung bilden, in die das elektronische Leistungsbauelement von oben her mit einem Teil seiner Höhe hineinragt und deren verbleibendes Volumen vorzugsweise vollständig mit dem elektrisch isolierenden und gut wärmeleitenden Kontaktmaterial ausgefüllt ist.

Umfasst die Elektronikbaueinheit mehrere elektronische Leistungsbauelemente, so können diese so angeordnet sein, dass sie im zusammengebauten Zustand von oben her in ein und dieselbe trogförmige Vertiefung hineinragen. Alternativ hierzu ist es erfindungsgemäß auch möglich, für jedes der zu kühlenden elektronischen Leistungsbauelemente in der Oberseite des Kühlkörpers eine gesonderte trogförmige Vertiefung vorzusehen, was den Vorteil bietet, dass die Bodenfläche einer jeden dieser Vertiefungen einen anderen, an die Höhe des Gehäuses des zugehörigen elektronischen Leistungsbauelements angepassten Abstand von der Leiterplatte besitzen kann.

Vorzugsweise können auf der dem Kühlkörper zugewandten Flachseite der Leiterplatte um das wenigstens eine elektronische Leistungsbauelement herum zusätzliche metallische Flächen vorgesehen sein, denen nicht unbedingt eine elektrische Funktion zukommt und die lediglich dazu dienen, die vom Leistungsbauelement erzeugte Wärme in verstärktem Maße parallel zur Ebene der Leiterplatte zu verteilen. Erfindungsgemäß ist zwischen diesen zusätzlichen metallischen Flächen und der ihnen zugewandten Oberseite des Kühlkörpers wieder eine den Zwischenraum ausfüllende Schicht aus einem elektrisch isolierenden und gut wärmeleitenden Kontaktmaterial vorgesehen. Dabei ist die elektrische Isolation nur dann erforderlich, wenn diese metallischen Flächen nicht potenzialfrei sind.

Wesentlich ist, dass die dem Kühlkörper zugewandten Oberflächen von Leiterbahnen und sonstigen metallischen Flächen, die dazu dienen, die vom elektronischen Leistungsbauelement ausgehende Wärme zunächst parallel zur Ebene der Leiterplatte und dann in etwa senkrecht zu dieser Richtung in den Kühlkörper ab- und umzuleiten, nicht von Lötstopp-Lack bedeckt sind, da dieser zwar ein guter elektrischer Isolator aber ein schlechter Wärmeleiter ist.

Um die Wärmeableitung parallel zur Ebene der Leiterplatte zu verbessern, kann insbesondere bei mehrlagigen Leiterplatten vorgesehen sein, dass zwischen den einzelnen Lagen mehrere zusätzliche, nicht notwendigerweise eine eigene elektrische Funktion besitzende, metallische Flächen vorgesehen und durch Termovias miteinander verbunden sind, wie dies beispielsweise in der WO 2010/018466 A2 beschrieben wird. Zusammenfassend ist festzustellen, dass sich eine erfindungsgemäße Elektronikbaueinheit durch einen äußerst geringen thermischen Widerstand zwischen dem oder den wärmeerzeugenden Leistungsbauelementen und dem diese Wärme an die Umgebung abführenden Kühlkörper auszeichnet, ohne dass hierfür irgendwelche Zusatzbauelemente (Glimerscheiben, Isolierfolien usw.) erforderlich wären. Somit führt die Erfindung zu geringeren Material- und Herstellungskosten. Überdies werden an die Bauelemente, insbesondere die Leiterplatte und den Kühlkörper keine hohen Toleranzanforderungen gestellt, wodurch die Herstellungskosten niedrig gehalten werden und sich die Montage vereinfacht.

Kühlkörper werden häufig durch Druckgussverfahren hergestellt, die sich durch eine hohe Geometriefreiheit auszeichnen. Die erfindungsgemäß bevorzugte Ausbildung der der Leiterplatte zugewandten Oberseite des Kühlkörpers mit wenigstens zwei im montierten Zustand einen unterschiedlichen Abstand zur Leiterplatte besitzenden Flächenbereichen kann daher ohne spanabhebende Bearbeitungsschritte und damit sehr kostengünstig realisiert werden.

Diese und andere vorteilhafte Ausgestaltungen einer erfindungsgemäßen Elektronikbaueinheit sind in den Unteransprüchen niedergelegt.

Die Erfindung wird im Folgenden anhand von Ausführungsbeispielen unter Bezugnahme auf die Zeichnung beschrieben; in dieser zeigen:

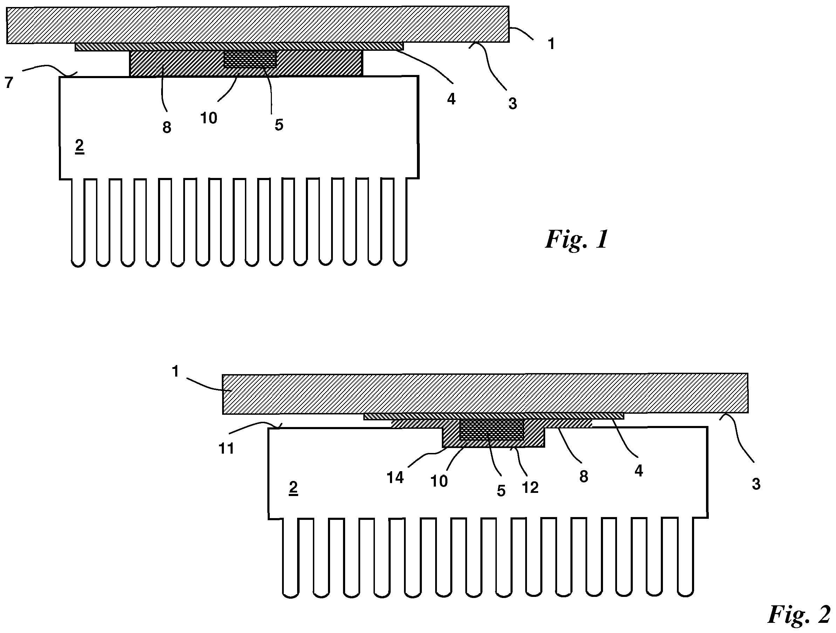

Fig. 1 eine stark schematisierte, teilweise geschnittene Seitenansicht einer Elektronikbaueinheit mit einem Kühlkörper, dessen der Leiterplatte zugewandte Oberseite einen einzigen, parallel zur Leiterplatte verlaufenden Flächenbereich aufweist, und mit einem bezüglich des Kühlkörpers zentral angeordneten elektronischen Leistungsbauelement, das keinen eigenen Kühlflansch besitzt,

Fig. 2 eine stark schematisierte, teilweise geschnittene Seitenansicht einer erfindungsgemäßen Elektronikbaueinheit mit einem Kühlkörper, dessen der Leiterplatte zugewandte Oberseite zwei in unterschiedlichen Abständen parallel zur Leiterplatte verlaufende Flächenbereiche aufweist, und mit einem bezüglich des Kühlkörpers zentral angeordneten elektronischen Leistungsbauelement, das keinen eigenen Kühlflansch besitzt,

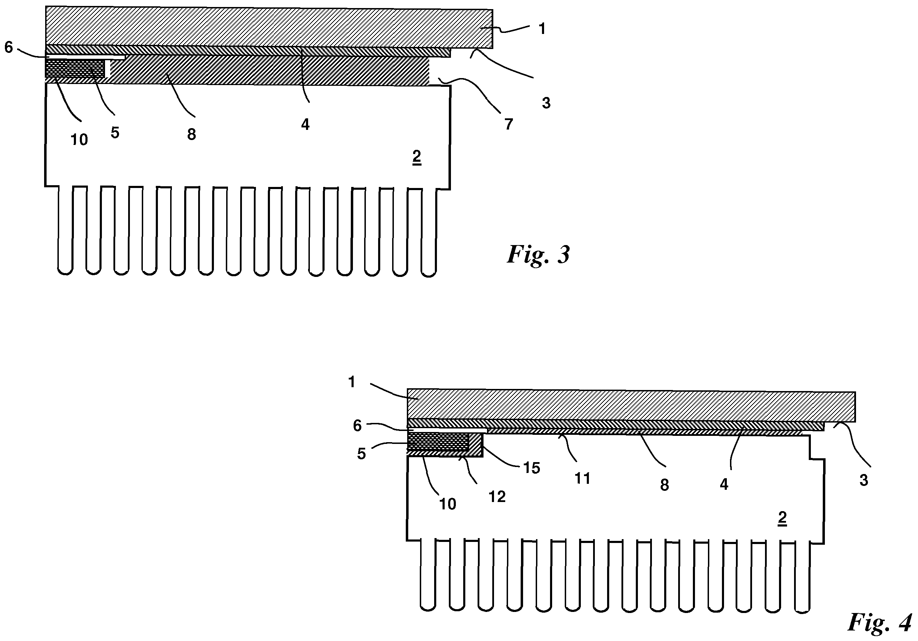

Fig. 3 eine der Fig. 1 entsprechende Seitenansicht einer Elektronikbaueinheit, bei welcher ein elektronisches Leistungsbauelement mit einem eigenen Kühlflansch im Bereich einer der Seitenkanten des nur einen einzigen, der Leiterplatte zugewandten Flächenbereich aufweisenden Kühlkörpers angeordnet ist,

Fig. 4 eine der Figur. 2 entsprechende Seitenansicht einer erfindungsgemäßen Elektronikbaueinheit, bei welcher ein elektronisches Leistungsbauelement mit eigenem Kühlflansch im Bereich einer der Seitenkanten des Kühlkörpers angeordnet ist, der zwei der Leiterplatte zugewandte, in unterschiedlichen Abständen zu dieser verlaufende Flächenbereiche aufweist, und

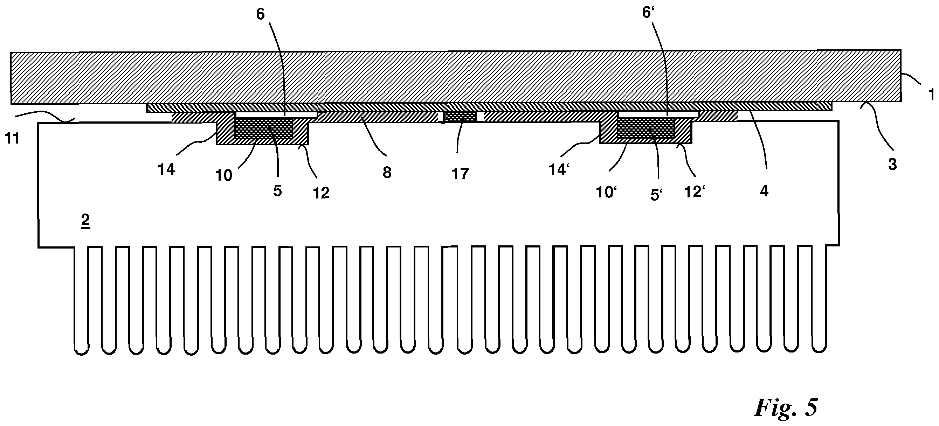

Fig. 5 eine stark schematisierte, teilweise geschnittene Seitenansicht einer erfindungsgemäßen Elektronikbaueinheit mit zwei elektronischen Leistungsbauelementen, von denen jedes einen eigenen Kühlflansch aufweist.

Alle in den Figuren gezeigten Ausführungsbeispiele sind nicht maßstabsgetreu wiedergegeben und die Abmessungen einzelner Teile bzw. Schichten sind insbesondere in vertikaler Richtung der Deutlichkeit halber stark vergrößert dargestellt. Im vorliegenden Zusammenhang verwendete Ausdrücke wie "darüber", "darunter", "oben", "unten", "links", "rechts", "horizontal" oder "vertikal" beziehen sich ausschließlich auf die jeweils beschriebene Zeichnungsfigur und definieren nicht die Einbaulage der verschiedenen Komponenten einer erfindungsgemäßen Elektronikbaueinheit in einer konkreten Anwendungssituation.

Die in jedem Fall vorhandenen Mittel zur gegenseitigen Verbindung von Leiterplatte und Kühlkörper sind der Einfachheit halber weggelassen.

Einander entsprechende Teile sind in den Figuren jeweils mit dem gleichen Bezugszeichen versehen.

Alle Figuren zeigen eine Leiterplatte 1, die an ihrer einem Kühlkörper 2 zugewandten Flachseite 3 wenigstens eine elektrische Leiterbahn 4 aufweist, die zusammen mit weiteren, in den Schnittansichten der Figuren nicht sichtbaren Leiterbahnen zum elektrischen Anschluss wenigstens eines elektronischen Leistungsbauelements 5 dient, dessen Gehäuse an der dem Kühlkörper 2 zugewandten Flachseite 3 der Leiterplatte 1 anliegt. Zusätzlich hierzu kann die Leiterplatte 1 auf beiden Flachseiten ein oder mehrere weitere elektrische und/oder elektronische Bauelemente tragen, die jedoch der Einfachheit halber nicht wiedergegeben sind. Auf der vom Kühlkörper 2 abgewandten Flachseite der Leiterplatte 1 können weitere, nicht dargestellte Leiterbahnen vorhanden sein.

In allen Figuren dient das wiedergegebene elektronische Leistungsbauelement 5 dadurch als Abstandshalter zwischen der Leiterplatte 1 und dem Kühlkörper 2, dass es einerseits an der Flachseite 3 der Leiterplatte 1 und andererseits an einem der Leiterplatte 1 zugewandten Flächenbereich 7 bzw. 12 der Oberseite des Kühlkörpers 2 anliegt, wobei der zwischen der Flachseite 3 und dem Flächenbereich 7 bzw. 12 verbleibende Zwischenraum mit einer Schicht 8 aus einem gut wärmeleitenden und im Allgemeinen auch elektrisch isolierenden Kontaktmaterial, beispielsweise einer Wärmeleitpaste bzw. einem Gap-Filler ausgefüllt ist. Diese Schicht 8 steht sowohl mit den das elektronische Leistungsbauelement 5 umgebenden Bereichen der Leiterplatte 1 und/oder der bzw. den auf der Flachseite 3 befindlichen Leiterbahnen 4 als auch mit dem der Leiterplatte 1 zugewandten Flächenbereich 7 bzw. 12 des Kühlkörpers 2 in engem, wärmeleitenden Kontakt. Insbesondere befindet sich auch zwischen der dem Kühlkörper 2 zugewandten Gehäuseoberfläche des elektronischen Leistungsbauelements 5 und dem Flächenbereich 7 bzw. 12 des Kühlkörpers 2 eine dünne Schicht 10 des Gap-Fillers, deren Dicke in den Figuren der Deutlichkeit halber überproportional groß dargestellt ist, weil diese dünne Schicht 10 bei einer maßstabsgetreuen Wiedergabe in den Figuren praktisch nicht sichtbar wäre.

Eine wesentliche Funktion dieser dünnen Schicht 10 besteht darin, einen guten Wärmeübergang auch dann sicherzustellen, wenn die Gehäuseoberfläche und der ihr zugewandte Flächenbereich 7 des Kühlkörpers 2 aufgrund von Unebenheiten oder wegen Verkantungen der Bauteile gegeneinander nicht perfekt aneinander anliegen.

Als die oben erwähnten, gut wärmeleitenden und elektrisch gut isolierenden Kontaktmaterialien können handelsübliche Wärmeleitpasten verwendet werden, wie sie beispielsweise von der OKS Spezialschmierstoffe GmbH oder der US-Firma Chemtronics und anderen geliefert werden. Insbesondere als Gap-Filler bezeichnete Wärmeleitmaterialien werden unter anderem von der zum Henkel-Konzern gehörenden Bergquist Company unter der Bezeichnung GF3500S35-00-60-50CC oder aber auch von der Firma Hala Contec GmbH & Co. KG unter der Bezeichnung TDG-L-SI-2C geliefert.

In Fig. 1 ist eine Variante einerer Elektronikbaueinheit dargestellt, die nicht unter den Schutzumfang des Anspruchs 1 fällt, bei der das elektronische Leistungsbauelement 5 bezüglich des der Leiterplatte 1 zugewandten Flächenbereichs 7 des Kühlkörpers 2 in etwa zentral angeordnet ist. Das gezeigte Leistungsbauelement 5 besitzt ein reines Kunststoffgehäuse, das einen vergleichsweise hohen Wärmeübergangswiderstand darstellt. Erfindungsgemäß wird in einem solchen Fall ein Gehäuse mit möglichst geringer Wandstärke verwendet. Die vom elektronischen Chip des Leistungsbauelementes 5 erzeugte Wärme kann einerseits über die zwischen dem Leistungsbauelement 5 befindliche dünne Schicht 10 des Gap-Fillers direkt nach unten in den Kühlkörper 2 abfließen und sich andererseits über die Leiterbahn 4 bzw. die diese Leiterbahn 4 tragende Flachseite 3 der Leiterplatte 1 in horizontaler Richtung verteilen, sodass die Temperatur der in unmittelbarer Nähe des Leistungsbauelements 5 befindlichen Bereiche der Leiterbahn 4 und der Leiterplatte 1 durch die vom Leistungsbauelement 5 abgegebene Wärme ebenfalls erhöht ist; die mit diesen Bereichen in engem Kontakt stehende Schicht 8 des Gap-Fillers bewirkt jedoch eine Ableitung dieser Wärme auf den Kühlkörper 2.

Somit werden zwei parallele Wärmeleitpfade geschaffen, von denen der eine sehr kurz ist und direkt vom Leistungsbauelement 5 über die dünne Gap-Filler-Schicht 10 zum Kühlkörper 2 führt, dabei aber einen durch die Größe des Bauelementgehäuses gegebenen, vergleichsweise kleinen Querschnitt aufweist, während der andere zunächst parallel zur Erstreckung der Leiterplatte 1 und dann von dieser schräg nach unten zum Kühlkörper 2 hin verläuft. Dieser zweite Wärmeleitpfad besitzt zwar eine deutlich größere Länge als der erstgenannte, weist aber einen Querschnitt mit einer wesentlich größeren Fläche auf, durch welche die längenbedingte Widerstandszunahme mehr als ausgeglichen wird, sodass sich insgesamt ein sehr kleiner Wärme-Übergangswiderstand ergibt.

Fig. 2 zeigt eine ähnliche Positionierung des Leistungsbauelements 5 sowohl bezüglich der Leiterplatte 1 als auch hinsichtlich des Kühlkörpers 2. Ein wesentlicher Unterschied besteht darin, dass hier die der Leiterplatte 1 zugewandte Oberfläche des Kühlkörpers 2 zwei Flächenbereiche 11 und 12 aufweist, die im montierten Zustand unterschiedliche Abstände von der dem Kühlkörper 2 zugewandten Flachseite 3 der Leiterplatte 1 besitzen. Der von der Leiterplatte 1 weiter entfernte Flächenbereich 12 bildet hier den Boden einer in der Oberseite des Kühlkörpers 2 ausgebildeten, trogförmigen Vertiefung 14, die vorzugsweise vollständig mit Gap-Filler ausgefüllt ist. Auch hier ist die bereits im Zusammenhang mit Fig. 1 geschilderte dünne Schicht 10 des Gap-Fillers zwischen der dem Kühlkörper 2 zugewandten Gehäusefläche des Leistungsbauelements 5 und dem Flächenbereich 12 vorhanden.

Die Differenz der Abstände, welche die Flächenbereiche 11 und 12 von der ihnen zugewandten Flachseite 3 der Leiterplatte 1 besitzen, ist so auf die Dicke des Gehäuses des Leistungsbauelements 5 und die Dicke der dünnen Schicht 10 des Gap-Fillers abgestimmt, dass zwischen der Oberseite des Kühlkörpers 2 und der Leiterbahn 4 nur ein sehr kleiner Zwischenraum mit einer Höhe von beispielsweise 0,2 mm verbleibt, sodass die diesen Zwischenraum ausfüllende Gap-Filler-Schicht 8 eine sehr geringe Dicke aufweist; durch diese Verkürzung der Länge der beiden zueinander parallelen Wärmeleitpfade senkrecht zu den Flächenbereichen 11 und 12 des Kühlkörpers 2 lässt sich der thermische Gesamtwiderstand für einen vom Leistungsbauelement 5 und der Unterseite 3 der Leiterplatte 1 zum Kühlkörper 2 erfolgenden Wärmeübergang gegenüber dem Beispiel der Fig. 1 nochmals erheblich verringern.

Bei dem in Fig. 3 dargestellten Ausführungsbeispiel, das nicht unter den Schutzumfang des Anspruchs 1 fällt, ist das elektronische Leistungsbauelement 5 in unmittelbarer Nähe einer der Seitenkanten des Kühlkörpers 2 positioniert, wie dies in manchen Anwendungsfällen aus schaltungstechnischen oder geometrischen Gründen erforderlich sein kann. Darüber hinaus besitzt das Kunststoffgehäuse des Leistungsbauelementes 5 einen nach außen geführten Kühlflansch 6, auf welchem der die Hitze erzeugende Halbleiterchip montiert ist.

Da der Kühlflansch 6 erfindungsgemäß unmittelbar und in engem Wärmekontakt an der unteren Flachseite 3 der Leiterplatte 1 angelötet ist, kann hier die erzeugte Wärme in vermehrtem Maße über die dort befindliche Leiterbahn 4 und eventuell noch weitere, im Schnitt der Figur nicht sichtbare, an dieser Flachseite 3 vorgesehene Metallflächen zunächst längs dieser Flachseite 3 abfließen, die jedoch gemäß der Erfindung vermittels der Gap-Filler-Schicht 8 über eine große Fläche thermisch an den Flächenbereich 7 des Kühlkörpers 2 angebunden ist. Somit wird hier für eine besonders gute Wärmeableitung vor allem parallel zur Erstreckung der Leiterplatte 1 und dann senkrecht hierzu in den Kühlkörper 2 gesorgt.

Zum Anlöten des Kühlflansches 6 des Leistungsbauelementes 5 an die Leiterplatte 1 kann ein handelsübliches SMD-Lot bzw. eine handelsübliche SMD-Paste verwendet werden, wie sie zum Beispiel von der Firma Stannol oder ähnlichen Herstellern geliefert werden.

Wie bereits erwähnt, kann diese gute thermische Anbindung dadurch verstärkt werden, dass die untere Flachseite 3 der Leiterplatte 1 überall dort, wo dies möglich ist, insbesondere auch in der zur Zeichenebene der Fig. 3 senkrechten Richtung zusätzliche Metallflächen aufweist, die ebenfalls über die Gap-Filler-Schicht 8 an den Flächenbereich 7 des Kühlkörpers 2 thermisch angebunden sind. Diese zusätzliche Metallflächen können entweder als elektrische Leiterbahnen dienen oder elektrisch ungenutzt sein und somit nur eine thermische Funktion erfüllen.

Als elektronische Leistungsbauelemente 5 finden vorzugsweise solche Verwendung, die ein sogenanntes SMD-Gehäuse (surface mounted device = oberflächenmontiertes Bauelement) aufweisen; diese Gehäuse haben im Allgemeinen eine kubische Form und ihre elektrischen Anschlüsse sind in einer der Gehäuseflachseiten so angeordnet, dass sie mit deren Oberfläche plan abschließen, dabei aber elektrisch voneinander isoliert sind. Im montierten Zustand liegt diese Gehäuseoberfläche eng an der Flachseite der Leiterplatte 1 an, welche die elektrischen Leiterbahnen trägt, die mit den elektrischen Anschlüssen des Gehäuses verlötet sind. Es sind SMD-Gehäuse für elektronische Leistungsbauelemente im Handel, deren Dicke bzw. Höhe senkrecht zu der die elektrischen Anschlüsse aufweisenden Gehäuseoberfläche 1 mm oder nur wenig mehr beträgt. Durch die erfindungsgemäße Verwendung solcher Leistungsbauelemente als Abstandshalter zwischen dem Kühlkörper 2 und der Leiterplatte 1 lassen sich außerordentlich kleine Abstände zwischen diesen beiden Bauteilen erzielen, sodass insbesondere dann, wenn diese Zwischenräume mit einem Gap-Filler ausgefüllt sind, eine ausgezeichnete Wärmeableitung gewährleistet ist.

Da aufgrund der erfindungsgemäßen Anordnung der auf einem von Masse verschiedenen elektrischen Potenzial liegende Kühlflansch 6 des Gehäuses des Leistungsbauelements 5 mit dem im Regelfall aus einem leitenden Metall, insbesondere Aluminium, bestehenden Kühlkörper 2 nicht in Berührung steht, kann dieser zur Kühlung von mehreren elektronischen Leistungsbauelementen eingesetzt werden, deren Kühlflansche auf unterschiedlichen elektrischen Potenzialen liegen.

Fig. 4 zeigt ein Ausführungsbeispiel, bei dem das Leistungsbauelement 5 in ähnlicher Weise positioniert ist wie in Fig. 3, mit dem Unterschied, dass auch hier die der Leiterplatte 1 zugewandte Oberseite des Kühlkörpers 2 zwei Flächenbereiche 11 und 12 aufweist, die im montierten Zustand unterschiedliche Abstände von der Leiterplatte 1 besitzen. Im vorliegenden Fall sind die beiden Flächenbereiche 11 und 12 stufenförmig gegeneinander abgesetzt, weil der Flächenbereich 12 direkt in die linke Seitenkante des Kühlkörpers 2 übergeht. Ansonsten gilt hier das Gleiche, was bezüglich der Wärmeableitung parallel zur Leiterplatte 1 oben in Verbindung mit Fig. 3 und bezüglich des möglichst kleinen Wärmewiderstandes zwischen der Leiterbahn 4 und dem Flächenbereich 11 in Verbindung mit Fig. 2 gesagt wurde. Der Fig. 4 ist zu entnehmen, dass auch der der Deutlichkeit halber sehr breit dargestellte Zwischenraum 15 mit Gap-Filler ausgefüllt ist, der zwischen der rechten Seitenfläche des Gehäuses des Leistungsbauelements 5 und der die beiden Flächenbereiche 11 und 12 miteinander verbindenden vertikalen Fläche des Kühlkörpers 2 vorhanden ist.

In Fig. 5 ist eine erfindungsgemäße Elektronikbaueinheit dargestellt, deren Kühlkörper 2 auf seiner der Leiterplatte 1 zugewandten Seite zwei Vertiefungen 14, 14' aufweist, in jede von denen ein elektronisches Leistungsbauelement 5, 5' in der gleichen Weise hineinragt und an einem den Boden der entsprechenden Vertiefung 14, 14' bildenden Flächenbereich 12, 12' des Kühlkörpers 2 über eine dünne Schicht 10, 10' des Gap-Fillers anliegt, wie dies im Zusammenhang mit Fig. 2 beschrieben wurde. Jedes der Leistungsbauelemente 5, 5' weist einen von unten her an der Leiterbahn 4 anliegenden Kühlflansch 6, 6' auf, das heißt, es wird hier beispielsweise davon ausgegangen, dass sich die Gehäuse der beiden Leistungsbauelemente 5, 5' auf dem gleichen elektrischen Potenzial befinden.

Bei einer Halbbrücke aus zwei Lietsungsbauelementen wären hier zwei Leiterbahnen vorhanden, die unterhalb der Bauteile an zugehörige Anschlusselemente, nämlich einen Kühlflansch oder eine Kühlplatte des einen Leistungsbauelementes 5 und an die anderen Anschlusselemente des anderen Leistungsbauelementes 5' führen.

Die Unterseite der Leiterbahn 4 weist einen Abstand zum Flächenbereich 11 des Kühlkörpers 2 auf, der mit einer Schicht 8 eines Gap-Fillers gefüllt ist, sodass auch hier ein Wärmeübergang von der Leiterplatte 1 und der an ihrer Unterseite befindlichen Leiterbahn 4 auf den Kühlkörper 2 über einen kurzen, einen sehr großen Querschnitt besitzenden Wärmeleitpfad stattfinden kann.

Um zu verhindern, dass es zu einem Kurzschluss zwischen der Leiterbahn 4 und dem Kühlkörper 2 kommen kann, wenn sich die Leiterplatte 1 im Bereich zwischen den beiden elektronischen Leistungsbauelementen 5, 5' nach unten durchbiegt und dabei die Schicht 8 des plastisch verformbaren Gap-Fillers so weit zur Seite drückt, dass keine ausreichende Isolation zwischen der Leiterbahn 4 und dem Kühlkörper 2 mehr vorhanden ist, ist in etwa in der Mitte zwischen den beiden elektronischen Leistungsbauelementen 5, 5' ein Steg 17 aus einem nicht komprimierbaren isolierenden Material, beispielsweise aus Lötstopp-Lack angeordnet.

Ansonsten ist es erfindungsgemäß von Wichtigkeit, dass in all den Bereichen, in denen metallische Leiterbahnflächen an der Unterseite der Leiterplatte 1 mit einer Schicht 8 eines gut wärmeleitenden Gap-Fillers in Berührung stehen, diese Leiterbahnflächen frei von Lötstopp-Lack sind, da dieser einen vergleichsweise hohen Wärmeleitwiderstand aufweist.

## Patentansprüche

1.  Elektronikbaueinheit, die Folgendes umfasst:

    - eine ebene Leiterplatte (1), die elektrische Leiterbahnen (4) aufweist,

    - wenigstens ein elektronisches Leistungsbauelement (5), das elektrische Anschlüsse aufweist und auf der Leiterplatte (1) so montiert ist, dass seine elektrischen Anschlüsse mit Leiterbahnen (4) der Leiterplatte (1) in elektrisch leitender Verbindung stehen,

    - einen Kühlkörper (2), der zum Abführen der von dem elektronischen Leistungsbauelement (5) im Betrieb erzeugten Wärme an die Umgebung dient und an seiner der Leiterplatte (1) zugewandten Oberseite wenigstens zwei ebene und zur Leiterplatte (1) parallel verlaufende Flächenbereiche (11, 12) aufweist, von denen wenigstens einer (11) im zusammengebauten Zustand einen ersten Abstand von der Leiterplatte (1) und wenigstens einer (12) einen zweiten Abstand von der Leiterplatte (1) aufweist, der größer als der erste Abstand ist, wobei der letztgenannte Flächenbereich (12) den Boden einer in der Oberseite des Kühlkörpers (2) ausgebildeten trogförmigen Vertiefung (14) bildet, in die das elektronische Leistungsbauelement (5) hineinragt, und an dem das Gehäuse des elektronischen Leistungsbauelements (5) über eine dazwischen liegende Schicht (10) aus einem zumindest gut wärmeleitenden Kontaktmaterial anliegt, und wobei das Volumen der trogförmigen Vertiefung (14), welches das Gehäuse des elektronischen Leistungsbauelements (5) umgibt, mit einem zumindest gut wärmeleitenden Kontaktmaterial ausgefüllt ist,

    - Befestigungsmittel, durch welche die Leiterplatte (1) und der Kühlkörper (2) miteinander verbunden sind,

    **dadurch gekennzeichnet,**

    - **dass** das wenigstens eine elektronische Leistungsbauelement (5) in der Weise als Abstandshalter zwischen dem Kühlkörper (2) und der Leiterplatte (1) dient, dass seine elektrischen Anschlüsse mit einer Oberfläche seines Gehäuses plan abschließen und diese Oberfläche an der die Leiterbahnen tragenden Flachseite der Leiterplatte (1) eng anliegt, und

    - **dass** zumindest in der Umgebung des wenigstens einen elektronischen Leistungsbauelements (5) der Freiraum zwischen der Leiterplatte (1) und dem Kühlkörper (2) mit einer Schicht (8) aus einem elektrisch isolierenden und gut wärmeleitenden Kontaktmaterial zumindest teilweise ausgefüllt ist.

2.  Elektronikbaueinheit nach Anspruch 1, **dadurch gekennzeichnet, dass** die wenigstens zwei ebenen Flächenbereiche (11, 12) des Kühlkörpers (2) stufenförmig gegeneinander abgesetzt sind.

**3.** Elektronikbaueinheit nach einem der vorhergehenden Ansprüche, bei der das Gehäuse des elektronischen Leistungsbauelementes (5) auf seiner Außenseite einen metallischen Kühlflansch (6) aufweist, **dadurch gekennzeichnet, dass** das elektronische Leistungsbauelement (5) so auf der Leiterplatte (1) montiert ist, dass der Kühlflansch (6) an der Leiterplatte (1) anliegt.

**4.** Elektronikbaueinheit nach Anspruch 3, **dadurch gekennzeichnet, dass** zwischen dem Kühlflansch (6) und der Leiterplatte (1) eine dünne Schicht aus einem elektrisch gut leitenden Kontaktmaterial vorgesehen ist.

**5.** Elektronikbaueinheit nach einem der Ansprüche 1 bis 4, **dadurch gekennzeichnet, dass** auf der dem Kühlkörper (2) zugewandten Flachseite (3) der Leiterplatte (1) um das wenigstens eine elektronische Leistungsbauelement (5) herum metallische Flächen für eine in Richtung dieser Flachseite (3) erfolgende Wärmeableitung vorgesehen sind.

**6.** Elektronikbaueinheit nach Anspruch 5, **dadurch gekennzeichnet, dass** die Oberflächen von Leitbahnen und / oder die metallischen Flächen auf der dem Kühlkörper (2) zugewandten Flachseite (3) der Leiterplatte (1) frei von Lötstopp-Lack sind.

**7.** Elektronikbaueinheit nach Anspruch 5 oder 6, **dadurch gekennzeichnet, dass** bei mehrlagigen Leiterplatten (1) zwischen den einzelnen Lagen mehrere solcher metallischen Flächen vorgesehen und über sogenannte Thermovias miteinander verbunden sind.

**8.** Elektronikbaueinheit nach einem der Ansprüche 1 bis 7, **dadurch gekennzeichnet, dass** auf längeren an der Unterseite der Leiterplatte (1) ausgebildeten Leitbahnen wenigstens ein schmaler Steg (17) aus Lötstopp-Lack vorgesehen ist, der dazu dient, bei einer Durchbiegung der Leiterplatte (1) einen Kurzschluss zwischen der betreffenden Leiterbahn und dem Kühlkörper (2) zu verhindern.

## Claims

**1.** An electronic assembly comprising:

- a planar printed circuit board (1) having electrical conductor tracks (4),
- at least one electronic power component (5) which has electrical connections and is mounted on the printed circuit board (1) in such a way that its electrical connections are in electrically conductive connection with conductor tracks (4) of the printed circuit board (1)

- a heat sink (2) which serves to dissipate the heat generated by the electronic power component (5) during operation to the environment and, on its upper side facing the printed circuit board (1), has at least two flat surface regions (11, 12) which extend parallel to the printed circuit board (1) and of which at least one (11), in the assembled state, is at a first distance from the printed circuit board (1) and at least one (12) is at a second distance from the printed circuit board (1) which second distance is greater than the first distance, the latter surface area (12) forming the bottom of a trough-shaped recess (14) formed in the upper side of the heat sink (2), into which recess the electronic power component (5) projects, and against which the housing of the electronic power component (5) rests via an interposed layer (10) of a contact material which is at least a good conductor of heat, and wherein the volume of the trough-shaped recess (14), which surrounds the housing of the electronic power component (5), is filled with a contact material which is at least a good conductor of heat,

- fastening means by which the printed circuit board (1) and the heat sink (2) are connected to one another,

**characterized**

- **in that** the at least one electronic power component (5) serves as a spacer between the heat sink (2) and the printed circuit board (1) in such a way that its electrical connections are flush with a surface of its housing and this surface bears closely against the flat side of the printed circuit board (1) carrying the conductor tracks, and

- **in that**, at least in the vicinity of the at least one electronic power component (5), the free space between the printed circuit board (1) and the heat sink (2) is at least partially filled with a layer (8) of an electrically insulating contact material with good thermal conductivity.

**2.** Electronic assembly according to claim 1, **characterised in that** the at least two flat surface regions (11, 12) of the heat sink (2) are offset from one another in in a stepped manner.

**3.** Electronic assembly according to one of the preceding claims, in which the housing of the electronic power component (5) has a metallic cooling flange (6) on its outer side, **characterized in that** the electronic power component (5) is mounted on the printed circuit board (1) in such a way that the cooling flange (6) bears against the printed circuit board (1).

**4.** Electronic assembly according to claim 3, **characterised in that** between the cooling flange (6) and the printed circuit board (1) a thin layer of an electrically highly conductive contact material is provided.

**5.** Electronic assembly according to one of the claims 1 to 4, **characterised in that** on the flat side (3) of the printed circuit board (1) facing the heat sink (2), metallic surfaces are provided around the at least one electronic power component (5) for heat dissipation along this flat side (3).

**6.** Electronic assembly according to claim 5, **characterised in that** the surfaces of conductive tracks and/or the metallic surfaces on the flat side (3) of the printed circuit board (1) facing the heat sink (2) are free of solder-stop lacquer.

**7.** Electronic assembly according to claim 5 or 6, **characterised in that**, in the case of multilayer printed circuit boards (1), a plurality of such metallic surfaces is provided between the individual layers and are connected to one another via so-called thermovias.

**8.** Electronic assembly according to one of the claims 1 to 7, **characterised in that** at least one narrow web (17) of solder resist is provided on longer conductive tracks formed on the underside of the printed circuit board (1), which web serves to prevent a short circuit between the relevant conductive track and the heat sink (2) in the event of a deflection of the printed circuit board (1).

**Revendications**

**1.** Unité électronique comprenant ce qui suit :

- un circuit imprimé plane (1) comportant des pistes électriques (4),
- au moins un composant électronique de puissance (5) qui présente des connexions électriques et qui est monté sur le circuit imprimé (1) de telle sorte que ses connexions électriques soient en connexion électriquement conductrice avec des pistes électriques (4) du circuit imprimé (1),
- un dissipateur thermique (2) qui sert à dissiper vers l'environnement la chaleur produite par le composant électronique de puissance (5) en fonctionnement et qui présente, sur sa face supérieure tournée vers le circuit imprimé (1), au moins deux zones de surface (11, 12) planes et parallèles à le circuit imprimé (1), dont au moins une (11) présente, à l'état assemblé, une première distance par rapport le circuit imprimé (1) et au moins une (12) deuxième distance par rapport le circuit imprimé (1) qui est supérieure à la première distance, cette dernière zone de surface (12) formant le fond d'une cavité (14) en forme d'auge formée dans la face supérieure du dissipateur thermique (2), dans laquelle le composant électronique de puissance (5) fait saillie, et contre lequel le boîtier du composant électronique de puissance (5) s'applique par l'intermédiaire d'une couche intermédiaire (10) en un matériau de contact au moins bon conducteur de la chaleur, et dans lequel l'espace de la cavité en forme d'auge (14), qui entoure le boîtier du composant électronique de puissance (5), est rempli d'un matériau de contact au moins bon conducteur de la chaleur,
- des moyens de fixation par lesquels le circuit imprimé (1) et le dissipateur thermique (2) sont reliés entre eux,

**caractérisé en ce**

- **que** le au moins un composant électronique de puissance (5) sert d'entretoise entre le dissipateur thermique (2) et le circuit imprimé (1) de telle sorte que ses connexions électriques se terminent à plat avec une surface de son boîtier et que cette surface s'applique étroitement contre le côté plat du circuit imprimé (1) portant les pistes conductrices, et
- **qu'**au moins dans l'environnement de l'au moins un composant électronique de puissance (5), l'espace libre entre du circuit imprimé (1) et le dissipateur thermique (2) est au moins partiellement rempli d'une couche (8) d'un matériau de contact électriquement isolant et bon conducteur de chaleur.

**2.** Unité électronique selon la revendication 1, **caractérisée en ce que** les au moins deux zones de surface planes (11, 12) du dissipateur thermique (2) sont décalées l'une par rapport à l'autre en escalier.

**3.** Unité électronique selon l'une des revendications précédentes, dans laquelle le boîtier du composant électronique de puissance (5) présente sur sa face extérieure une plaque de refroidissement métallique (6), **caractérisée en ce que** le composant électronique de puissance (5) est monté sur le circuit imprimé (1) de telle sorte que la plaque de refroidissement (6) s'applique contre le circuit imprimé (1).

**4.** Unité électronique selon la revendication 3, **caractérisée en ce qu'**une couche mince d'un matériau de contact électriquement bon conducteur est prévue entre la plaque de refroidissement (6) et le circuit imprimé (1).

**5.** Unité électronique selon l'une des revendications 1 à 4, **caractérisée en ce que** des surfaces métalliques sont prévues sur la face plate (3) du circuit imprimé (1) tournée vers le dissipateur thermique (2), autour du au moins un composant électronique de puissance (5), pour une dissipation thermique en long de cette face plate (3).

6. Unité électronique selon la revendication 5, **caractérisée en ce que** les surfaces des pistes conductrices et/ou les surfaces métalliques sur la face plate (3) du circuit imprimé (1) orientée vers le dissipateur thermique (2) sont exemptes de vernis d'arrêt de soudure.

7. Unité électronique selon la revendication 5 ou 6, **caractérisée en ce que**, dans le cas de circuits imprimés multicouches (1), plusieurs surfaces métalliques de ce type sont prévues entre les différentes couches et sont reliées entre elles par ce que l'on appelle des thermovias.

8. Unité électronique selon l'une des revendications 1 à 7, **caractérisé en ce qu'**il est prévu, sur des pistes conductrices plus longues formées sur la face inférieure du circuit imprimé (1), au moins une barrette étroite (17) en vernis d'arrêt de soudure, qui sert à empêcher un court-circuit entre la piste conductrice concernée et le dissipateur thermique (2) en cas de flexion du circuit imprimé (1).

Fig. 1

Fig. 2

Fig. 3

Fig. 4

EP 3 483 930 B1

*Fig. 5*

**IN DER BESCHREIBUNG AUFGEFÜHRTE DOKUMENTE**

**In der Beschreibung aufgeführte Patentdokumente**

- DE 10249436 A1
- US 20080006915 A1
- DE 4009445 A1
- WO 2010018466 A2